# EUROPEAN PATENT APPLICATION

(11) **EP 4 614 567 A1**
(43) Date of publication of application: **10.09.2025**
(21) Application number: 23890550.9
(22) Date of filing: 30.10.2023
(51) Int. Cl.: H01L 23/495

(54) **POWER MODULE AND ELECTRONIC DEVICE HAVING SAME**

(30) Priority: 17.11.2022 CN 202211442177; 28.04.2023 CN 202310495887; 26.06.2023 CN 202321635269 U
(71) Applicant: Hisense Home Appliances Group Co., Ltd., Foshan, Guangdong 528303 (CN)
(72) Inventor: CHENG, Zhangming, Foshan, Guangdong 528303 (CN); LI, Zhengkai, Foshan, Guangdong 528303 (CN); ZHOU, Wenjie, Foshan, Guangdong 528303 (CN); LIU, Jian, Foshan, Guangdong 528303 (CN); XIE, Dilin, Foshan, Guangdong 528303 (CN); BIE, Qingfeng, Foshan, Guangdong 528303 (CN)
(74) Representative: Casalonga
(86) International application number: PCT/CN2023/127874
(87) International publication number: WO 2024/104114

(57) **Abstract**

Provided are a power module and an electronic device having same. The power module comprises a package, a heat dissipation substrate provided in the package, and a plurality of power chips. The package has a first surface and a second surface that are provided opposite to each other in the thickness direction of the power module, and comprises one or more residual portions located on the first surface. The heat dissipation substrate has a third surface and a fourth surface that are provided opposite to each other in the thickness direction of the power module. The heat dissipation substrate comprises a conductive layer, the surface of the conductive layer close to the first surface is the third surface, and the fourth surface is flush with the second surface, so that the fourth surface is exposed from the package. The plurality of power chips are arranged on the conductive layer at intervals in the length direction of the power module. The orthographic projections of the edges of the one or more residual portions on the conductive layer and the orthographic projections of the edges of the power chips on the conductive layer are staggered.

## Description

This application claims priority to Chinese Patent Application No. 202211442177.8, filed on November 17, 2022; Chinese Patent Application No. 202310495887.5, filed on April 28, 2023; and Chinese Patent Application No. 202321635269.8, filed on June 26, 2023, which are incorporated herein by reference in their entireties.

### TECHNICAL FIELD

The present disclosure relates to the technical field of electronic devices, and in particular to a power module and an electronic device having same.

### BACKGROUND

Intelligent power modules (IPM) have characteristics of high current density, low saturation voltage, low driving power, high switching frequency, high functional integration level, and high reliability. The intelligent power modules may be widely applied to many fields such as electronics, automobiles, rail transit, industrial equipment, new and renewable sources of energy, smart grid, etc. Generally, for the power module, a resin is used to package power chips and control chips inside the power module, so that the characteristic of a high integration level of the power module may be achieved.

### SUMMARY

In an aspect, a power module is provided. The power module includes a packaging body, a heat dissipation substrate disposed in the packaging body, and a plurality of power chips. The packaging body has a first surface and a second surface disposed opposite to each other in a thickness direction of the power module, and includes one or more residual portions located on the first surface. The heat dissipation substrate has a third surface and a fourth surface disposed opposite to each other in the thickness direction of the power module. The heat dissipation substrate includes a conductive layer. A surface of the conductive layer proximate to the first surface is the third surface, and the fourth surface is flush with the second surface, so that the fourth surface is exposed from the packaging body. The plurality of power chips are disposed on the conductive layer and arranged at intervals in a length direction of the power module. Orthogonal projections of edges of the one or more residual portions on the conductive layer are staggered with orthogonal projections of edges of the power chips on the conductive layer.

In another aspect, an electronic device is provided. The electronic device includes the power module described above.

### BRIEF DESCRIPTION OF THE DRAWINGS

FIG. 1 is a diagram showing a structure of a power module in the related art;
FIG. 2 is a diagram showing a structure of a power module, in accordance with some embodiments of the present disclosure;
FIG. 3 is a diagram showing another structure of a power module, in accordance with some embodiments of the present disclosure;
FIG. 4 is a diagram showing yet another structure of a power module, in accordance with some embodiments of the present disclosure;
FIG. 5 is a plan view of a power module, in accordance with some embodiments of the present disclosure;
FIG. 6 is an enlarged view of the N region in the power module in FIG. 5;
FIG. 7 is a front packaging effect diagram of a power module, in accordance with some embodiments of the present disclosure;
FIG. 8 is a perspective view of a power module, in accordance with some embodiments of the present disclosure;
FIG. 9 is an enlarged view of the M region in the power module in FIG. 8;
FIG. 10 is another plan view of a power module, in accordance with some embodiments of the present disclosure;
FIG. 11 is yet another plan view of a power module, in accordance with some embodiments of the present disclosure;
FIG. 12 is yet another plan view of a power module, in accordance with some embodiments of the present disclosure;
FIG. 13 is yet another plan view of a power module, in accordance with some embodiments of the present disclosure;
FIG. 14 is a back packaging effect diagram of a power module, in accordance with some embodiments of the present disclosure;
FIG. 15 is a perspective view of a power module, in accordance with some embodiments of the present disclosure;
FIGS. 16 to 18 are schematic diagrams of a packaging process of a power module, in accordance with some embodiments of the present disclosure;
FIG. 19 is a schematic diagram of an annular dent on a first surface of a power module, in accordance with some embodiments of the present disclosure;
FIG. 20 is a diagram showing yet another structure of a power module, in accordance with some embodiments of the present disclosure;
FIG. 21 is a schematic diagram of a packaging mold corresponding to the power module in FIG. 20; and
FIG. 22 is a block diagram of an electronic device, in accordance with some embodiments of the present disclosure.

### DETAILED DESCRIPTION

Some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, the terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. In the description of the embodiments of the present disclosure, the term "a/the plurality of" means two or more unless otherwise specified.

In the description of some embodiments, the expression "connected", and derivative thereof may be used. For example, the term "connected" may be used in the description of some embodiments to indicate that two or more components are in direct physical or electrical contact with each other. The embodiments disclosed herein are not necessarily limited to the content herein.

The phrase "A and/or B" includes following three combinations: only A, only B, and a combination of A and B.

The term "about", "substantially", and "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

Exemplary embodiments are described herein with reference to sectional views and/or plan views as idealized exemplary drawings. In the accompanying drawings, thicknesses of layers and regions are enlarged for clarity. The exemplary embodiments of the present disclosure should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in devices, and are not intended to limit the scope of the exemplary embodiments.

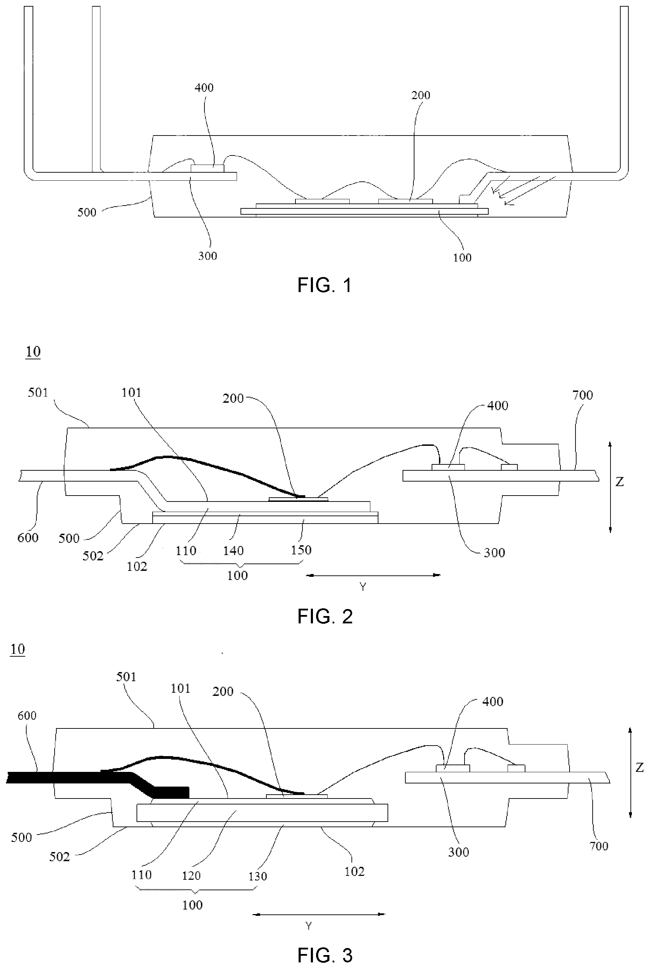

Generally, power modules are disposed in the electronic devices, so as to achieve application of functions of the electronic devices. In the related art, generally, driving chips and power chips are packaged by means of the injection molding process, so as to obtain a packaging body of the power module. FIG. 1 is a diagram showing a structure of a power module. The power module 10 may include a heat dissipation substrate 100, a power chip 200 disposed on the heat dissipation substrate 100, a driving frame 300, a driving chip 400 disposed on the driving frame 300, and a packaging body 500 configured to package the heat dissipation substrate 100, the power chip 200, the driving frame 300, and the driving chip 400.

During the injection molding, the heat dissipation substrate 100 provided with the power chip 200 and the driving frame 300 provided with the driving chip 400 may be fixed in a cavity of a packaging mold, and then the resin is injected into the cavity through a resin injection opening of the packaging mold, and the demolding is performed after the resin cures, so that the packaging of the power module may be completed. However, in the process of injecting the resin, a non-fixed end of the heat dissipation substrate 100 cannot be perfectly attached to a surface of the packaging mold, and the heat dissipation substrate 100 may warp when heated. In addition, the flowing resin may also impact the heat dissipation substrate 100. All these may affect the adhesion between the heat dissipation substrate 100 and the packaging mold, and cause the flowing resin to overflow to a back surface (i.e., a side away from the power chip 200) of the heat dissipation substrate 100, thereby causing the resin to overflow to the back surface of the substrate, affecting the performance of the power module 10.

On this basis, a power module is provided in the embodiments of the present disclosure, the power module may be an intelligent power module (IPM). In combination with FIGS. 2 to 5, the power module 10 includes a heat dissipation substrate 100, a plurality of power chips 200 disposed on the heat dissipation substrate 100, and a packaging body 500 disposed outside the heat dissipation substrate 100 and the power chips 200. The heat dissipation substrate 100 may include a conductive layer 110, and the conductive layer 110 is configured to arrange the plurality of power chips 200 thereon. That is to say, the conductive layer 110 may serve as pads for the power chips 200. The plurality of power chips 200 are disposed on the conductive layer 110 and arranged at intervals in a length direction X of the power module 10.

The packaging body 500 has a first surface 501 and a second surface 502 disposed opposite to each other in a thickness direction Z of the power module 10. The first surface 501 is located on a side of the power chip 200 away from the heat dissipation substrate 100 and may be referred to as a top surface of the packaging body 500. The second surface 502 is located on a side of the heat dissipation substrate 100 away from the power chip 200 and may be referred to as a bottom surface of the packaging body 500.

The heat dissipation substrate 100 is located in the packaging body 500, and has a third surface 101 and a fourth surface 102 disposed opposite to each other in the thickness direction Z of the power module 10. The third surface 101 is a surface of the heat dissipation substrate 100 proximate to the first surface 501, and the fourth surface 102 is a surface of the heat dissipation substrate 100 proximate to the second surface 502. The fourth surface 102 is flush with the second surface 502, so that the fourth surface 102 is exposed from the second surface 502 (e.g., the bottom surface) of the packaging body 500. A surface of the conductive layer 110 proximate to the first surface 501 is the third surface 101 of the heat dissipation substrate 100. That is to say, the conductive layer 110 is a film layer closest to the first surface 501 (e.g., located at the top) in the heat dissipation substrate 100.

It may be understood that an area of the fourth surface 102 of the heat dissipation substrate 100 is less than an area of the second surface 502 of the packaging body 500. Therefore, in a case where the fourth surface 102 is flush with the second surface 502, the fourth surface 102 occupies only a portion of the second surface 502.

It will be noted that a structure of the power module 10 is described by referring to a length direction X, width direction Y and thickness direction Z of the power module 10. The thickness direction Z of the power module 10 refers to a direction perpendicular to a plane where the heat dissipation substrate 100 is located. The length direction X and the width direction Y of the power module 10 are both directions parallel to the plane where the heat dissipation substrate 100 is located, and the length direction X of the power module 10 refers to an arrangement direction of a plurality of pads configured to arrange the plurality of power chips 200, and the width direction Y of the power module 10 refers to an extending direction of any pad.

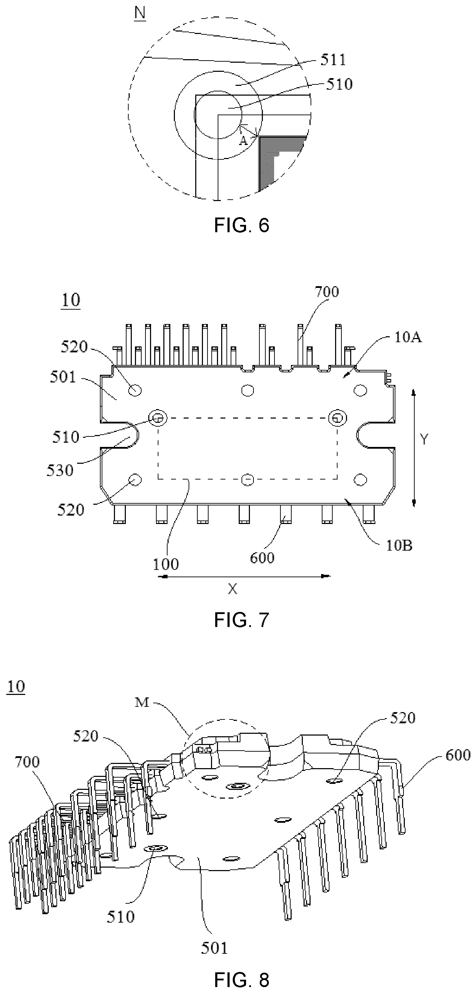

On this basis, in order to avoid a problem that the resin overflows to the back surface of the heat dissipation substrate 100 in the packaging process of the power module 10, in combination with FIGS. 7 to 13, one or more residual portions 510 are disposed on the first surface 501 of the packaging body 500, and orthogonal projections of edges of the residual portions 510 on the conductive layer 110 are staggered with orthogonal projections of edges of the power chips 200 on the conductive layer 110. It may be understood that the residual portions 510 refer to dents left on a surface of the packaging body 500 by ejector pins of the packaging mold after the packaging of the power module 10 is completed.

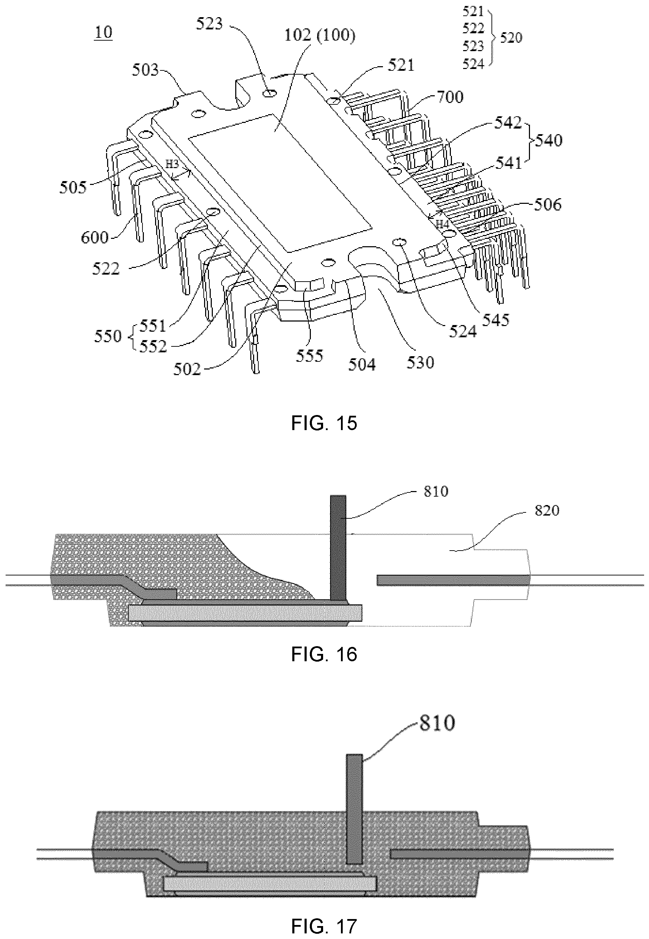

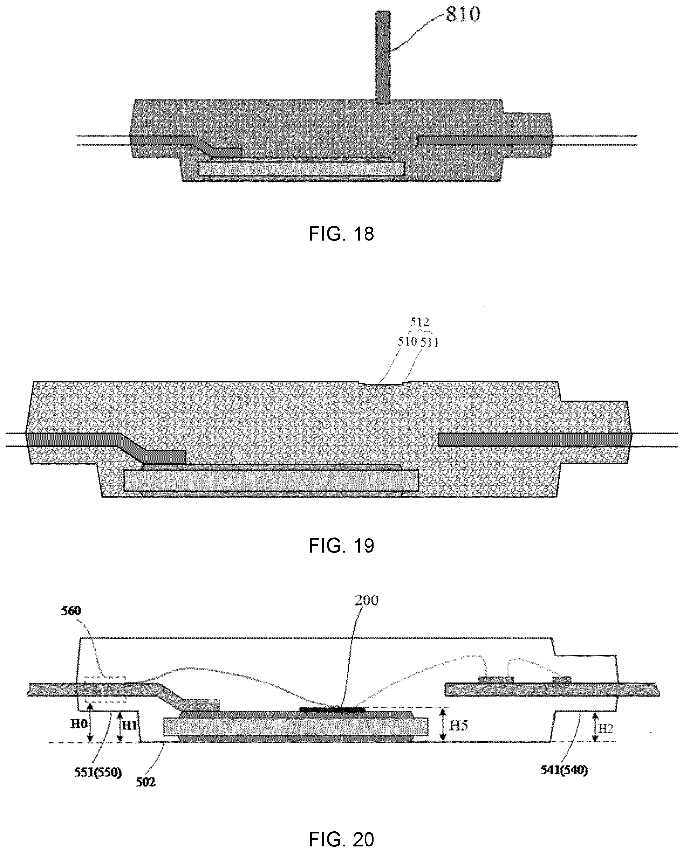

For example, FIG. 16 is a schematic diagram when an ejector pin of the packaging mold presses the heat dissipation substrate in the injection molding process, FIG. 17 is a schematic diagram when the ejector pin starts to reset in the injection molding process, and FIG. 18 is a schematic diagram when the ejector pin has been completely reset in the injection molding process. As shown in FIGS. 16 to 18, when a main structure of the power module 10 is packaged, the ejector pins 810 of the packaging mold may be used to press the heat dissipation substrate 100 from above (i.e., a side where the power chips 200 are disposed) the heat dissipation substrate 100 by passing through ejector pin plates and sleeves, so that the heat dissipation substrate 100 may be tightly pressed downward. The position of the heat dissipation substrate 100 may be kept stable in the process of injecting the resin into a cavity 820 of the packaging mold. When the resin almost cures, the ejector pins 810 are controlled to start to reset, and the packaging mold is completely removed after the packaging is completed, so that the heat dissipation substrate 100 may be controlled to be tightly attached to the surface of the packaging mold in the entire packaging process. It may be seen that the ejector pin 810 of the packaging mold may be a retractable ejector pin. When the resin is injected, the ejector pin 810 extends out of the sleeve to fix the heat dissipation substrate 100. When filling of the resin is complete and the pressure is maintained, the ejector pin 810 retracts, so that the entire plastic packaging process may be completed. In this way, the ejector pin 810 may extend out and retract in the space limited by the sleeve, which is conducive to improving the accuracy of the up-down movement of the ejector pin 810.

It will be noted that in a case where the ejector pin 810 is used to fix the heat dissipation substrate 100, the ejector pin 810 may pass through the ejector pin plate and the sleeve and be fixed by a bottom plate, an oil passage provides power to an ejector rod to push out the ejector pin 810, and the ejector pin 810 is reset by an action of a reset spring or a reverse oil passage after the power provided by the oil passage is cut off.

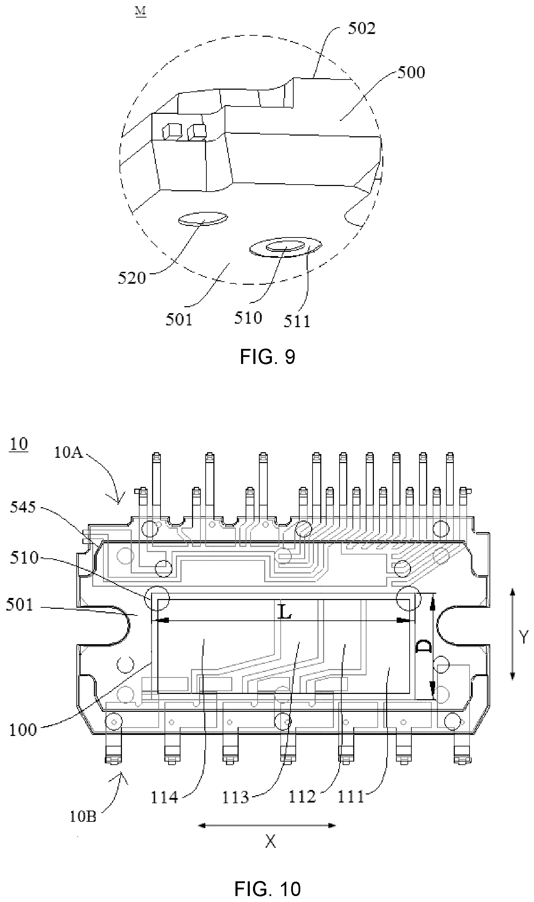

Reset positions of the ejector pin and the sleeve are closer to the heat dissipation substrate 100 than a surface of the cavity of the packaging mold, so as to prevent the resin from filling into the sleeve. Therefore, two annular dents (e.g., ring-shaped dents) that are nested are finally formed on the first surface 501 of the packaging body 500. The reset position of the ejector pin 810 is closer to the heat dissipation substrate 100 than the reset position of the sleeve. Therefore, as shown in FIGS. 9 and 19, the annular dent finally formed on the first surface 501 of the packaging body 500 is a stepped hole 512 formed by the sleeve and the ejector pin 810. An edge of the sleeve corresponds to an outer circle (i.e., an edge of a dent 511 corresponding to the sleeve) in the annular dent, and an edge of the ejector pin corresponds to an inner circle (i.e., an edge of the residual portion 510) in the annular dent, and a depth of the residual portion 510 is greater than a depth of the dent 511 corresponding to the sleeve.

In this way, the ejector pins 810 may apply pressure to the heat dissipation substrate 100 during the filling of the resin, so that the heat dissipation substrate 100 may not be easily tilted due to the impact of the flowing resin, thereby ensuring that the position of the heat dissipation substrate 100 is stable and preventing the injected resin from overflowing to the back surface of the heat dissipation substrate 100. When the ejector pins 810 are removed, the resin has cured, so that the position of the heat dissipation substrate 100 may still be kept stable. In this way, it may be ensured that the heat dissipation substrate 100 is tightly attached to the bottom portion of the packaging mold, thereby preventing the resin from overflowing to the back surface of the heat dissipation substrate 100.

In the power module 10 provided in the embodiments of the present disclosure, the packaging body 500 is formed after the resin injected into the cavity of the packaging mold cures. In the packaging process of the power module 10, the top surface of the heat dissipation substrate 100 is pressed by the ejector pins of the packaging mold, so that the heat dissipation substrate 100 may be tightly attached to the bottom surface of the packaging mold without tilting in the process of injecting the resin, thereby preventing the resin from overflowing to the back surface of the heat dissipation substrate 100, which is conducive to the packaging of the power module 10. On this basis, the formed power module 10 may have one or more residual portions 510 on the first surface 501 of the packaging body 500, and the fourth surface 102 of the heat dissipation substrate 100 away from the power chip 200 may be flush with the second surface 502 (i.e., the bottom surface) of the packaging body 500, so that the fourth surface 102 of the heat dissipation substrate 100 may be exposed from the bottom surface of the packaging body 500, thereby ensuring that the power module 10 has a good packaging effect. In addition, when the ejector pins press the heat dissipation substrate 100, the orthogonal projections of the residual portions 510 on the conductive layer 110 of the heat dissipation substrate 100 may be staggered with the orthogonal projections of the edges of the power chips 200 on the conductive layer 110 by controlling the positions of the ejector pins to be staggered from the positions of the power chips 200 on the heat dissipation substrate 100. In this way, it is possible to ensure that the ejector pins are not in contact with the power chips 200 in the packaging process and prevent the ejector pins from interfering with the power chips 200, so that damage to the power chips 200 may be avoided, which is conducive to ensuring the normal operation of the power chips 200, thereby ensuring that power module 10 is used normally.

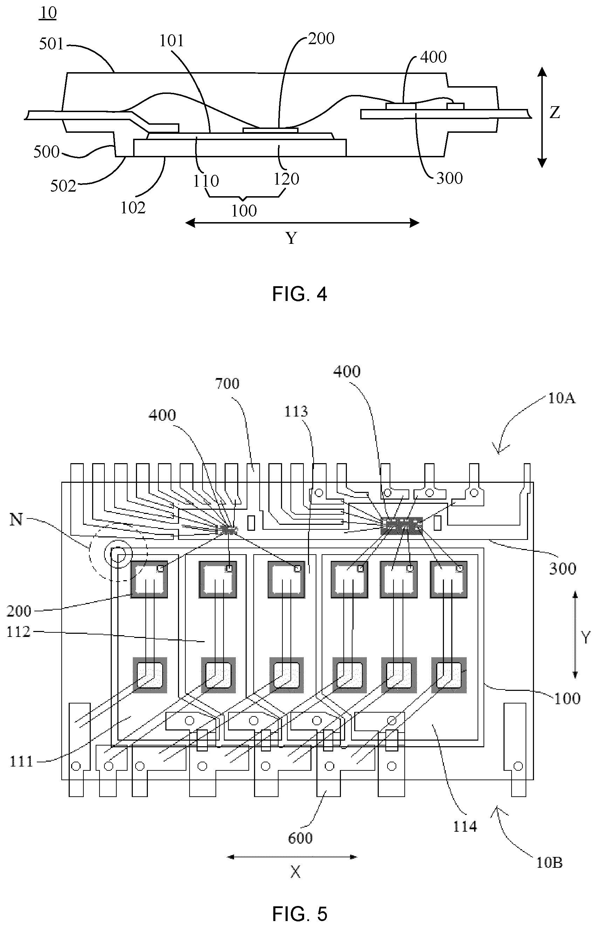

For the convenience of description, in combination with FIGS. 5 and 10 to 15, two sides of the power module 10 in the width direction Y thereof may be referred to as a driving side 10A and a power side 10B, respectively. In some embodiments, the power module 10 may include a heat dissipation substrate 100, a plurality of power chips 200 disposed on the heat dissipation substrate 100, a plurality of power pins 600 connected to the heat dissipation substrate 100, a driving frame 300, at least one driving chip 400 disposed on the driving frame 300, a plurality of driving pins 700 connected to the driving frame 300, and a packaging body 500. The plurality of power pins 600 are arranged at intervals in the length direction X of the power module 10, an end of the power pin 600 is connected to the heat dissipation substrate 100, and another end of the power pin 600 extends out of the packaging body 500. The plurality of driving pins 700 are arranged at intervals in the length direction X of the power module 10, an end of the driving pin 700 is connected to the driving frame 300, and another end of the driving pin 700 extends out of the packaging body 500. The plurality of driving pins 700 and the plurality of power pins 600 are located on the two sides of the power module 10 in the width direction Y thereof, respectively. A side where the plurality of driving pins 700 are located is referred to as the driving side 10A, and a side where the plurality of power pins 600 are located is referred to as the power side 10B.

The driving chip 400 is electrically connected to the power chip 200 and configured to drive the power chip 200 to operate, so as to achieve functions of the power module 10. For example, the driving chip 400 may include a low voltage driving chip and a high voltage driving chip. A portion of the plurality of driving pins 700 are electrically connected to the low voltage driving chip, and another portion of the plurality of driving pins are electrically connected to the high voltage driving chip. When the power module 10 is operating, the plurality of driving pins 700 and the plurality of power pins 600 may be connected to external controllers, so as to achieve electrical connection between an internal circuit of the power module 10 and an external circuit, so that the normal use of the power module 10 may be achieved.

The heat dissipation substrate 100, the power chips 200, the driving frame 300 and the driving chips 400 are all disposed in the packaging body 500. The packaging body 500, for example, may be a protective shell formed by the packaging resin, and the packaging body 500 is configured to provide protection for the structure inside the packaging body 500, so that the assembly between the driving frame 300 and the heat dissipation substrate 100 may be reliable, and good protection is provided for the driving chip 400 and the power chips 200, thereby improving the performance and reliability of the power module 10.

In the embodiments of the present disclosure, as shown in FIGS. 5 and 10 to 13, the conductive layer 110 may include a plurality of base islands arranged at intervals in the length direction X of the power module 10, such as a first base island 111, a second base island 112, a third base island 113 and a fourth base island 114 arranged at intervals in sequence. The plurality of power chips 200 are disposed on the plurality of base islands. The number of power chips 200 disposed on each base island may be designed according to actual requirements.

It will be noted that areas of the first base island 111, the second base island 112, the third base island 113 and the fourth base island 114 may be different, so that the numbers of power chips 200 disposed on the base islands may also be different. For example, the areas of the first base island 111, the second base island 112 and the third base island 113 are all less than the area of the fourth base island 114. That is to say, the fourth base island 114 has the largest area. In this case, one power chip 200, such as a low voltage power chip, may be disposed on each of the first base island 111, the second base island 112 and the third base island 113, and three power chips 200, such as high voltage power chips, may be disposed on the fourth base island 114, and each of the low voltage power chips and the high voltage power chips is located at a position of the base island proximate to the driving side 10A. In this way, the plurality of high voltage power chips are all integrated on the fourth base island 114, which may save space and improve the structural compactness of the power module 10. In addition, the low voltage power chip and the high voltage power chip are arranged at an interval, which may not only meet the power requirements of different circuits, but also avoid mutual interference between different power regions, thereby ensuring the stability and reliability of the power chips.

For example, the power chip 200 may include a metal-oxide-semiconductor (MOS) chip, an insulated gate bipolar transistor (IGBT) chip, a fast recovery diode (FRD) chip, two chips consisting of the IGBT chip and the FRD chip, or a reverse-conducting insulated gate bipolar transistor (RC-IGBT) chip where the FRD chip is disposed in the IGBT chip. In this way, at least one of the IGBT chip, FRD chip and RC-IGBT chip may be selected to be used according to requirements, thereby improving the convenience of use.

It may be seen from the embodiments described above that one or more residual portions 510 are disposed on the first surface 501 of the packaging body 500. It may be seen that the number and distribution of the ejector pins are related to a size of the heat dissipation substrate 100, considering that the residual portions 510 are dents left on the surface of the packaging body 500 by the ejector pins in the packaging process, and the ejector pins are provided to prevent the resin from overflowing to the back surface of the heat dissipation substrate 100.

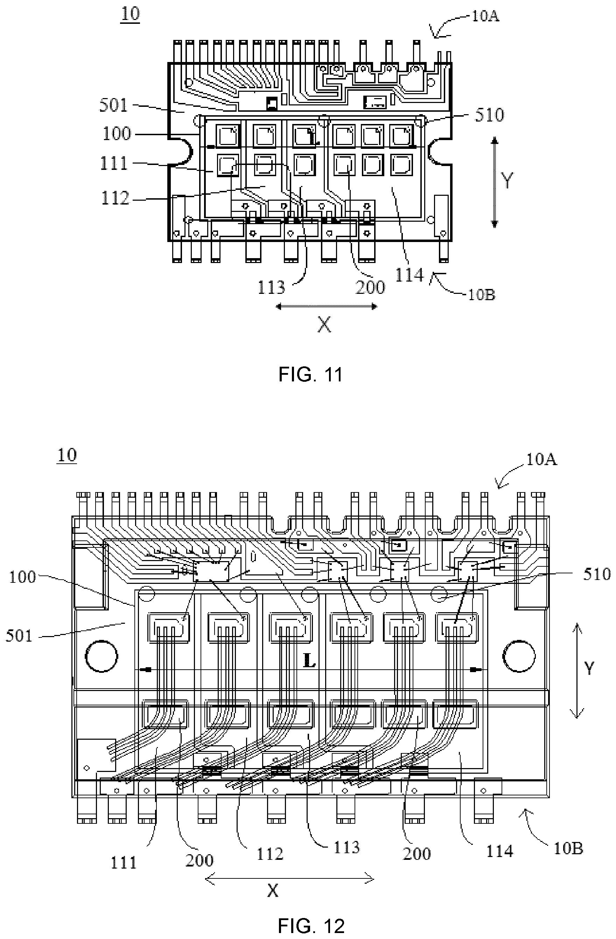

In some embodiments, as shown in FIGS. 10 and 11, a dimension of the heat dissipation substrate 100 in the length direction X of the power module 10 is L, and the number of the one or more residual portions 510 is n. In a case where L is less than or equal to 40 mm (i.e., L ≤ 40 mm), n is greater than or equal to 2 and less than or equal to 4 (i.e., 2 ≤ n ≤ 4), and L and n are both positive integers. That is to say, in a case where the length of the heat dissipation substrate 100 is less than or equal to 40 mm, the number of the provided residual portions 510 is within a range of 2 to 4, inclusive. In this case, these residual portions 510 may at least include two residual portions 510 located at two ends in the length direction X of the power module 10, and in the thickness direction Z of the power module 10, the two residual portions 510 correspond to two base islands located at two ends in the length direction X of the power module 10 in the plurality of base islands, respectively.

It will be noted that the residual portion 510 corresponds to the base island, which means that in the thickness direction Z of the power module 10, the orthogonal projection of the residual portion 510 on the conductive layer 110 of the heat dissipation substrate 100 is at least partially located on the base island. That is to say, the orthogonal projection of the residual portion 510 on the conductive layer 110 overlaps with the base island.

For example, the conductive layer 110 of the heat dissipation substrate 100 includes the first base island 111, the second base island 112, the third base island 113 and the fourth base island 114 that are arranged at intervals in sequence in the length direction X of the power module 10. The length L of the heat dissipation substrate 100 is less than or equal to 40 mm. Two, three or four residual portions 510 are disposed on the first surface 501 of the packaging body 500 and arranged at intervals in the length direction X of the power module 10. The orthogonal projections of two residual portions 510 located at two ends in these residual portions 510 on the conductive layer 110 overlap with the first base island 111 and the fourth base island 114, respectively.

In this way, in a case where the dimension L of the heat dissipation substrate 100 in the length direction X of the power module 10 does not exceed 40 mm, 2 to 4 ejector pins may be used to fix the heat dissipation substrate 100 in the packaging process. In this case, 2 to 4 residual portions 510 may be correspondingly formed on the first surface 501 of the packaging body 500. Since the heat dissipation substrate 100 has a small dimension, each of the two base islands located at two ends in the length direction X of the power module 10 in the plurality of base islands corresponds to one residual portion 510. That is to say, the two base islands located at two ends may be pressed by their corresponding ejector pins in the packaging process, so that the heat dissipation substrate 100 with a small dimension may be attached to the surface of the packaging mold, thereby preventing the resin from overflowing to the back surface of the heat dissipation substrate 100, which is conducive to ensuring the packaging effect of the power module 10 and improving the reliability of the power module 10.

In some examples, as shown in FIG. 10, in a case where L is less than or equal to 25 mm (i.e., L ≤ 25 mm), n is equal to 2 (i.e., n = 2). That is to say, in a case where the length of the heat dissipation substrate 100 is less than or equal to 25 mm, the number of the provided residual portions 510 is two. The orthogonal projections of the two residual portions 510 on the conductive layer 110 overlap with two base islands (e.g., the first base island 111 and the fourth base island 114) located at two ends in the plurality of base islands, respectively. The ejector pins, for example, may press the first base island 111 and the fourth base island 114 in the packaging process.

For example, in a case where the size of the heat dissipation substrate 100 is less than 25 × 12 mm (e.g., a maximum size of the packaging body 500 is 35.6 mm × 18.8 mm, and the size of the heat dissipation substrate 100 is 22.7 mm × 9.15 mm), the heat dissipation substrate 100 may be fixed by a two-point fixing method (i.e., using two ejector pins). The two ejector pins may press non-fixed ends (i.e., end portions located on the driving side 10A) of the first base island 111 and the fourth base island 114, such as two vertex corners of the conductive layer 110 located on the driving side 10A.

In this case, only two base islands at two ends are fixed, so that the heat dissipation substrate 100 with the dimension L less than or equal to 25 mm may be well attached to the surface of the packaging mold, and a speed of packaging the power module 10 may also be increased.

On this basis, a minimum distance between two adjacent power chips 200 is B, a maximum section dimension of the residual portion 510 is C, and B is less than a sum of C and 0.8 mm (i.e., B < C + 0.8 mm). For example, a minimum distance between the power chip 200 disposed on the first base island 111 and the power chip 200 disposed on the second base island 112 is B, and the residual portion 510 is in a shape of a ring, a diameter of an outer circle of the residual portion 510 is C, and B is less than a sum of C and 0.8 mm (i.e., B < C + 0.8 mm).

In a case where B is equal to a sum of C and 0.8 mm (i.e., B = C + 0.8 mm), the distance B between two adjacent power chips 200 may control a distance between an edge of an end portion of the ejector pin and the power chip 200 within a safe range in the packaging process. In other words, in a case where no ejector pin is disposed between two adjacent power chips 200, the condition that B < C + 0.8 mm may be satisfied. That is to say, there is a small distance between two adjacent power chips 200. Such arrangement may be applicable to the heat dissipation substrate 100 with a small dimension in the length direction X of the power module 10, which is conducive to achieving miniaturization of the power module 10.

Furthermore, the maximum section dimension C of the residual portion 510 may be equal to 1.2 mm (i.e., C = 1.2 mm), and the minimum distance B between two adjacent power chips 200 may be less than 2 mm (i.e., B < 2 mm). For example, an end surface of the ejector pin 810 is in a shape of a circle, and the diameter C of the ejector pin 810 is 1.2 mm. The minimum distance B between two adjacent power chips 200 in the length direction X of the power module 10 is less than 2 mm. Such arrangement may make the distance between two adjacent power chips 200 small, so that the dimension of the power module 10 in the length direction X thereof may be reduced.

In some other examples, as shown in FIG. 11, in a case where L is greater than 25 mm and less than or equal to 32 mm (i.e., 25 mm < L ≤ 32 mm), n is equal to 3 (i.e., n = 3). That is to say, in a case where the length of the heat dissipation substrate 100 is greater than 25 mm and less than or equal to 32 mm, the number of the provided residual portions 510 is three. In the three residual portions 510, the orthogonal projection of the residual portion 510 located in a middle in the length direction X of the power module 10 on the conductive layer 110 overlaps with two adjacent base islands (e.g., the second base island 112 and the third base island 113, or the third base island 113 and the fourth base island 114) of the plurality of base islands at the same time, and the orthogonal projections of two residual portions 510 located at two ends in the length direction X of the power module 10 on the conductive layer 110 overlap with two base islands (e.g., the first base island 111 and the fourth base island 114) located at two ends in the plurality of base islands, respectively. The ejector pins, for example, may press the first base island 111, the fourth base island 114, and at least one base island in the middle in the packaging process.

For example, in a case where the size of the heat dissipation substrate 100 is within a range of 25 mm × 12 mm to 32 mm × 15 mm, inclusive (e.g., the maximum size of the packaging body 500 is 38 mm × 24 mm, and the size of the heat dissipation substrate 100 is 30.2 mm × 14.2 mm), the heat dissipation substrate 100 may be fixed by a three-point fixing method (i.e., using three ejector pins). The three ejector pins may press two vertex corners and a middle portion of the non-fixed end of the heat dissipation substrate 100. One of the ejector pins may press a middle position of an edge of the heat dissipation substrate 100 located on the driving side 10A, and this position corresponds to two adjacent base islands, which is conducive to fixing the two base islands at the same time, and another two ejector pins may press two vertex corners of the heat dissipation substrate 100 located on the driving side 10A, which is conducive to fixing two ends of the heat dissipation substrate 100.

In this case, two base islands located at two ends are fixed and a middle position of the conductive layer 110 in the length direction X of the power module 10 is fixed, so that the heat dissipation substrate 100 with the dimension L greater than 25 mm and less than or equal to 32 mm may be well attached to the surface of the packaging mold. In addition, centers of the three residual portions 510 may be disposed in a same straight line. In this way, in a case where the three ejector pins press the heat dissipation substrate 100 at the same time, the non-fixed end of the heat dissipation substrate 100 may be ensured to be subjected to even force, so that the deformation of the heat dissipation substrate 100 caused by the stress generated in the resin flowing process may be avoided, thereby improving the adhesion between the heat dissipation substrate 100 and the packaging mold.

In yet some other examples, in a case where L is greater than 32 mm and less than or equal to 40 mm (i.e., 32 mm < L ≤ 40 mm), n is equal to 4 (i.e., n = 4). That is to say, in a case where the length of the heat dissipation substrate 100 is greater than 32 mm and less than or equal to 40 mm, the number of the provided residual portions 510 is four. In the four residual portions 510, the orthogonal projections of two residual portions 510 located in the middle in the length direction X of the power module 10 on the conductive layer 110 overlap with two base islands (e.g., the second base island 112 and the third base island 113) located in the middle in the plurality of base islands, and the orthogonal projections of two residual portions 510 located at two ends in the length direction X of the power module 10 on the conductive layer 110 overlap with two base islands (e.g., the first base island 111 and the fourth base island 114) located at two ends in the plurality of base islands. The ejector pins may press the first base island 111, the second base island 112, the third base island 113, and the fourth base island 114 in the packaging process.

For example, in a case where the size of the heat dissipation substrate 100 is within a range of 32 mm × 15 mm to 40 mm × 16 mm, inclusive, the heat dissipation substrate 100 may be fixed by a four-point fixing method (i.e., using four ejector pins). The four ejector pins may press two vertex corners and two positions of the middle portion of the non-fixed end of the heat dissipation substrate 100, respectively. Two of the ejector pins may press the two vertex corners of the heat dissipation substrate 100 located on the driving side 10A, which is conducive to fixing the base islands located at two ends, and another two ejector pins may press edges of the two base islands in the middle of the heat dissipation substrate 100 located on the driving side 10A, which is conducive to fixing the base islands located in the middle.

In this case, each base island is fixed, so that the heat dissipation substrate 100 with the dimension L greater than 32 mm and less than or equal to 40 mm may be well attached to the surface of the packaging mold, and the speed of packaging the power module 10 may also be increased.

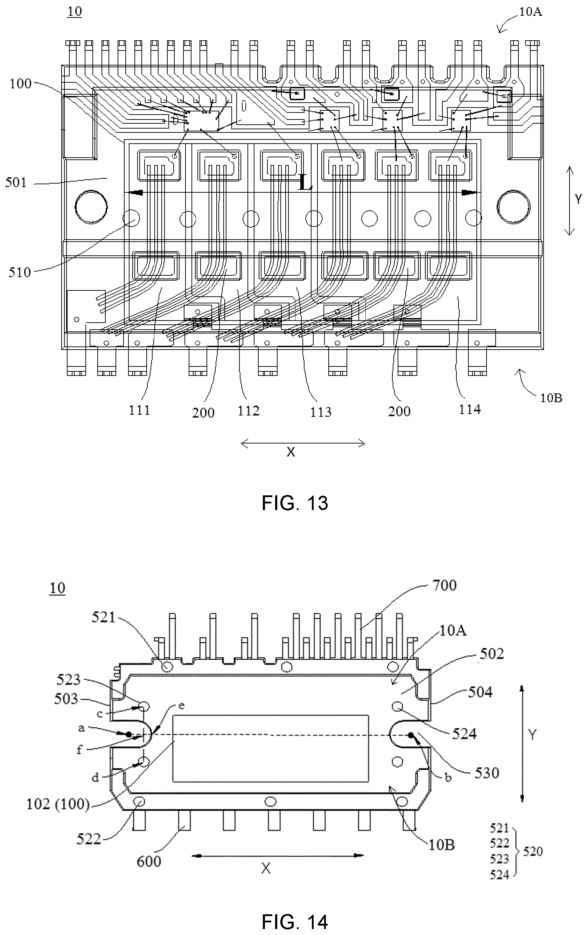

In some other embodiments, as shown in FIGS. 12 and 13, the dimension of the heat dissipation substrate 100 in the length direction X of the power module 10 is L, and the number of one or more residual portions 510 is n. In a case where L is greater than 40 mm (i.e., L > 40 mm), n is greater than 4 (i.e., n > 4), and L and n are both positive integers. That is to say, in a case where the length of the heat dissipation substrate 100 is greater than 40 mm, the number of the provided residual portions 510 is greater than four. In this case, each base island corresponds to at least one residual portion 510 in the thickness direction Z of the power module 10.

It may be understood that each base island corresponds to at least one residual portion 510, which means that for any base island, the orthogonal projection of at least one residual portion 510 on the conductive layer 110 of the heat dissipation substrate 100 overlaps with the base island. The numbers of the residual portions 510 corresponding to the base islands may be same or different.

For example, the conductive layer 110 of the heat dissipation substrate 100 includes the first base island 111, the second base island 112, the third base island 113 and the fourth base island 114 that are arranged at intervals in sequence in the length direction X of the power module 10, and the area of the fourth base island 114 is greater than that of other base islands. The length L of the heat dissipation substrate 100 is greater than 40 mm. Five, six or more residual portions 510 are disposed on the first surface 501 of the packaging body 500 and arranged at intervals in the length direction X of the power module 10. In these residual portions 510, the orthogonal projection of at least one residual portion 510 on the conductive layer 110 overlaps with the first base island 111, the orthogonal projection of at least one residual portion 510 on the conductive layer 110 overlaps with the second base island 112, the orthogonal projection of at least one residual portion 510 on the conductive layer 110 overlaps with the third base island 113, and the orthogonal projections of at least two residual portions 510 on the conductive layer 110 overlap with the fourth base island 114.

In this way, in a case where the dimension L of the heat dissipation substrate 100 in the length direction X of the power module 10 is greater than 40 mm, five or more ejector pins may be used to fix the heat dissipation substrate 100 in the packaging process. In this case, two or more residual portions 510 may be correspondingly formed on the first surface 501 of the packaging body 500. Since the heat dissipation substrate 100 has a large dimension, each base island corresponds to at least one residual portion 510. That is to say, each base island may be pressed by at least one corresponding ejector pin in the packaging process, so that the heat dissipation substrate 100 with a large dimension may be attached to the surface of the packaging mold, thereby preventing the resin from overflowing to the back surface of the heat dissipation substrate 100, which is conducive to ensuring the packaging effect of the power module 10 and improving the reliability of the power module 10.

In some examples, as shown in FIG. 12, in a case where L is greater than 40 mm (i.e., L > 40 mm), n is equal to 5 (i.e., n = 5). That is to say, in a case where the length of the heat dissipation substrate 100 is greater than 40 mm, the number of the provided residual portions 510 is five. In the five residual portions 510, the orthogonal projections of three residual portions 510 on the conductive layer 110 overlap with the first base island 111, the second base island 112, and the third base island 113, respectively, and the orthogonal projections of another two residual portions 510 on the conductive layer 110 overlap with the fourth base island 114.

For example, in a case where the size of the heat dissipation substrate 100 is greater than 40 mm × 16 mm (e.g., the maximum size of the packaging body 500 is 52.5 mm × 31 mm, and the size of the heat dissipation substrate 100 is 40.9 mm × 17.3 mm), five ejector pins may be used to press two vertex corners and three positions of the middle portion of the non-fixed end of the heat dissipation substrate 100, respectively. One ejector pin may press an edge of the first base island 111 located on the driving side 10A and proximate to the vertex corner, one ejector pin may press an edge of the second base island 112 located on the driving side 10A and proximate to the vertex corner, one ejector pin may press an edge of the third base island 113 located on the driving side 10A and proximate to the vertex corner, and another two ejector pins may press a middle portion of an edge of the fourth base island 114 located on the driving side 10A.

In the packaging process, the ejector pins may press the first base island 111, the second base island 112, the third base island 113 and the fourth base island 114. Moreover, since the area of the fourth base island 114 is greater than the areas of the first base island 111, the second base island 112 and the third base island 113, the number of ejector pins pressing on the fourth base island 114 is also greater than the numbers of ejector pins pressing on other base islands. In this case, each base island is pressed and a base island with a large area is pressed at a plurality of positions, so that the heat dissipation substrate 100 with a large dimension may be well attached to the surface of the packaging mold.

In some other examples, as shown in FIG. 13, in a case where L is greater than 40 mm (i.e., L > 40 mm), n is greater than 5 (i.e., n > 5). That is to say, in a case where the length of the heat dissipation substrate 100 is greater than 40 mm, the number of the provided residual portions 510 is greater than five. In these residual portions 510, the orthogonal projection of one residual portion 510 on the conductive layer 110 overlaps with an edge of a side of the first base island 111 away from the second base island 112, the orthogonal projection of one residual portion 510 on the conductive layer 110 overlaps with edges of the first base island 111 and the second base island 112 that are proximate to each other, the orthogonal projection of one residual portion 510 on the conductive layer 110 overlaps with edges of the second base island 112 and the third base island 113 that are proximate to each other, the orthogonal projection of one residual portion 510 on the conductive layer 110 overlaps with edges of the third base island 113 and the fourth base island 114 that are proximate to each other, and the orthogonal projections of the remaining residual portions 510 on the conductive layer 110 overlap with the fourth base island 114.

For example, in a case where the size of the heat dissipation substrate 100 is greater than 40 mm × 16 mm (e.g., the maximum size of the packaging body 500 is 52.5 mm × 31 mm, and the size of the heat dissipation substrate 100 is 40.9 mm × 17.3 mm), more than five, for example seven, ejector pins may be used to press a plurality of positions of a middle portion between the non-fixed end and a fixed end of the heat dissipation substrate 100. One ejector pin may press a middle portion of an edge of a side of the first base island 111 away from the second base island 112, one ejector pin may press middle portions of edges of the first base island 111 and the second base island 112 that are proximate to each other, one ejector pin may press middle portions of edges of the second base island 112 and the third base island 113 that are proximate to each other, one ejector pin may press middle portions of edges of the third base island 113 and the fourth base island 114 that are proximate to each other, one ejector pin may press a middle portion of an edge of a side of the fourth base island 114 away from the third base island 113, and another two ejector pins may press middle position of the fourth base island 114.

In the packaging process, the ejector pins may press the position between any adjacent base islands of the first base island 111, the second base island 112, the third base island 113 and the fourth base island 114, the edge of the first base island 111 away from the fourth base island 114, and the fourth base island 114, in the middle portion of the heat dissipation substrate 100 in the width direction Y of the power module 10. Moreover, since the area of the fourth base island 114 is greater than the areas of the first base island 111, the second base island 112 and the third base island 113, the number of ejector pins pressing the fourth base island 114 is also greater than the numbers of ejector pins pressing other base islands. In this case, the middle portions of the edges of the plurality of base islands are pressed and the base island with a large area is pressed at a plurality of positions, so that the heat dissipation substrate 100 with a large dimension may be well attached to the surface of the packaging mold.

In some embodiments, as shown in FIGS. 7 to 12, in a case where the number n of residual portions 510 disposed on the first surface 501 of the packaging body 500 is less than or equal to 5 (i.e., n ≤ 5), the orthogonal projections of the n residual portions 510 on the conductive layer 110 overlap with edges of the plurality of base islands located on the driving side 10A. As shown in FIG. 13, in a case where the number n of the residual portions 510 disposed on the first surface 501 of the packaging body 500 is greater than 5 (i.e., n > 5), the orthogonal projections of the n residual portions 510 on the conductive layer 110 are located in the middle portions of the plurality of base islands in the width direction Y of the power module 10. Such arrangement may prevent the middle portion of the heat dissipation substrate 100 with a large size in the width direction Y of the power module 10 from warping, so that the heat dissipation substrate 100 may be fixed stably, thereby preventing the resin from overflowing to the back surface of the heat dissipation substrate 100.

On this basis, as shown in FIGS. 7 to 11, in a case where the number n of the residual portions 510 disposed on the first surface 501 of the packaging body 500 is less than or equal to 5 (i.e., n ≤ 5), orthogonal projections of centers of two residual portions 510 located at two ends on the conductive layer 110 coincide with vertexes of two corners of the conductive layer 110 located on the driving side 10A. In this way, it is possible to not only ensure that the ejector pins may stably press the conductive layer 110 in the packaging process, but also to reduce areas of the base islands occupied by the ejector pins to the greatest extent, so that an area of the base islands configured to arrange the power chips 200 may be increased. It may be understood that this arrangement manner of the residual portions 510 may be applicable to the heat dissipation substrates 100 with any size, and the smaller the size of the heat dissipation substrate 100, the more obvious the advantage of this arrangement manner.

For example, as shown in FIGS. 7 to 10, two residual portions 510 are disposed on the first surface 501 of the packaging body 500, and the orthogonal projections of the centers of the two residual portions 510 on the conductive layer 110 coincide with the vertexes of the two corners of the conductive layer 110 located on the driving side 10A. In an example where an outer contour of the residual portion 510 is in a shape of a circle, an orthogonal projection of a center of one residual portion 510 on the conductive layer 110 coincides with a vertex of the first base island 111 located on the driving side 10A and away from the fourth base island 114, and an orthogonal projection of a center of another residual portion 510 on the conductive layer 110 coincides with a vertex of the fourth base island 114 located on the driving side 10A and away from the first base island 111.

In this way, in the packaging process, each of two ends of the conductive layer 110 in the length direction X of the power module 10 may be pressed by the ejector pin, so that the heat dissipation substrate 100 is difficult to shift at a position proximate to the first base island 111 and a position proximate to the fourth base island 114, which ensures that the fourth surface 102 of the heat dissipation substrate 100 and the second surface 502 of the packaging body 500 are in a same plane, thereby preventing the resin from overflowing to the back surface of the heat dissipation substrate 100.

It may be seen from the embodiments described above that for the power modules 10 with different sizes, the sizes of the heat dissipation substrate 100 are also different. The number n (i.e., the number of ejector pins corresponding to each base island) of the residual portions 510 corresponding to each base island and the distribution positions (i.e., the positions where the ejector pins press the base islands) of the residual portions 510 are designed according to the dimension L of the heat dissipation substrate 100 in the length direction X of the power module 10, which may solve the fitting problem between each of the heat dissipation substrates 100 in the power modules 10 with different sizes and the packaging mold in a targeted manner, so as to prevent the resin from overflowing to the back surface of the heat dissipation substrate 100 and obtain a good packaging effect. In addition, the processes for removing the resin overflowing to the surface of the heat dissipation substrate 100 may also be reduced, which is conducive to improving of production efficiency.

In some embodiments, as shown in FIGS. 5 and 6, a minimum distance A between an orthogonal projection of a power chip 200 closest to a residual portion 510 in the plurality of power chips 200 on the conductive layer 110 and an orthogonal projection of an edge of the residual portion 510 on the conductive layer 110 is greater than 0.45 mm (i.e., A > 0.45 mm).

For example, one residual portion 510 is formed at a position of the first surface 501 of the packaging body 500 corresponding to a vertex corner of the first base island 111 located on the driving side 10A and away from the fourth base island 114. The first base island 111 is provided with a power chip 200 proximate to the residual portion 510, and a minimum distance between an upper left vertex (referring to FIG. 5) of the power chip 200 and an edge of an orthogonal projection of the residual portion 510 on the conductive layer 110 is A, and A is greater than 0.45 mm (i.e., A > 0.45 mm).

In a case where the minimum distance A between the power chip 200 closest to the residual portion 510 in the plurality of power chips 200 and the residual portion 510 is less than 0.45 mm, a distance between the orthogonal projection of the residual portion 510 on the conductive layer 110 and the power chip 200 is small. That is to say, a distance between an edge of the end surface of the ejector pin and the power chip 200 is small in the packaging process. In this case, if the position of the ejector pin deviates, the ejector pin may easily be in contact with the power chip 200, which may cause the ejector pin to crush the power chip 200. Therefore, in the embodiments of the present disclosure, the minimum distance A between the power chip 200 closest to the residual portion 510 and the edge of the orthogonal projection of the residual portion 510 on the conductive layer 110 is set to be greater than 0.45 mm (i.e., A > 0.45 mm), so that the distance between the edge of the ejector pin and the power chip 200 may be controlled within a safe range when the end portion of the ejector pin is in contact with the conductive layer 110, thereby preventing the ejector pin from being in contact with the power chip 200 and avoiding the risk that the ejector pin crushes the power chip 200.

In some embodiments, as shown in FIGS. 14 and 15, a plurality of demolding portions 520 are disposed on the second surface 502 of the packaging body 500. For example, the demolding portion 520 may be a blind hole, which is a dent left on the second surface 502 of the packaging body 500 in the demolding process. Force applied to the packaging body 500 may be dispersed in the demolding process by providing the plurality of demolding portions 520, thereby preventing the packaging body 500 from being damaged or deformed.

In some examples, the plurality of demolding portions 520 may include a plurality of first demolding portions 521 and a plurality of second demolding portions 522. The plurality of first demolding portions 521 and the plurality of second demolding portions 522 are located at two edges of the second surface 502 in the width direction Y of the power module 10, respectively, and the plurality of first demolding portions 521 and the plurality of second demolding portions 522 are both arranged at intervals in the length direction X of the power module 10. For example, the plurality of demolding portions 520 may include three first demolding portions 521 arranged at intervals in the length direction X of the power module 10 and three second demolding portions 522 arranged at intervals in the length direction X of the power module 10. The first demolding portions 521 are located on the driving side 10A of the power module 10, and the second demolding portions 522 are located on the power side 10B of the power module 10.

In this way, demolding pins disposed at positions corresponding to the first demolding portions 521 and the second demolding portions 522 may extend out after the power module 10 has been packaged, so as to separate the packaging body 500 from the mold, which is conducive to the demolding of the power module 10. In addition, by providing the plurality of first demolding portions 521 and the plurality of second demolding portions 522, the packaging body 500 has the corresponding demolding pins at a plurality of positions corresponding to the length direction X of the power module 10 and a plurality of positions corresponding to the width direction Y of the power module 10, so that the demolding stability of the packaging body 500 may be improved.

In some other examples, the plurality of demolding portions 520 may further include a plurality of third demolding portions 523 and a plurality of fourth demolding portions 524. The plurality of third demolding portions 523 and the plurality of fourth demolding portions 524 are located between the plurality of first demolding portions 521 and the plurality of second demolding portions 522 in the width direction Y of the power module 10. The packaging body 500 has a first side 503 and a second side 504 opposite to each other in the length direction X of the power module 10. The plurality of third demolding portions 523 are located between the heat dissipation substrate 100 and the first side 503 of the packaging body 500, and the plurality of fourth demolding portions 524 are located between the heat dissipation substrate 100 and the second side 504 of the packaging body 500. For example, the plurality of demolding portions 520 may include two third demolding portions 523 and two fourth demolding portions 524 located between the first demolding portion 521 and the second demolding portion 522 in the width direction Y of the power module 10. The two third demolding portions 523 are located between the first base island 111 and the first side 503 of the packaging body 500 in the length direction X of the power module 10, and are arranged at an interval in the width direction Y of the power module 10. The two fourth demolding portions 524 are located between the fourth base island 114 and the second side 504 of the packaging body 500 in the length direction X of the power module 10, and are arranged at an interval in the width direction Y of the power module 10.

In this way, the demolding pins disposed at the positions corresponding to the third demolding portions 523 and the fourth demolding portions 524 may extend out after the power module 10 has been packaged, so as to separate the packaging body 500 from the mold, which is conducive to the demolding of the power module 10. In addition, the first demolding portions 521 and the second demolding portions 522 are disposed at the edges of the packaging body 500, and the third demolding portions 523 and the fourth demolding portions 524 are disposed in the middle portion of the packaging body 500, so that the demolding pins may be correspondingly disposed at the edges and middle portion of the packaging body 500, thereby improving the demolding stability of the packaging body 500.

In some embodiments, as shown in FIGS. 14 and 15, the plurality of third demolding portions 523 are planar symmetrical to each other with respect to a center of the packaging body 500 in the width direction Y of the power module 10, and the plurality of fourth demolding portions 524 are planar symmetrical to each other with respect to a center of the packaging body 500 in the width direction Y of the power module 10. That is to say, the plurality of third demolding portions 523 are symmetrical to each other with respect to the up-down direction in FIG. 17, and the plurality of fourth demolding portions 524 are symmetrical to each other with respect to the up-down direction in FIG. 17. And/or, the plurality of third demolding portions 523 are planar symmetrical to the plurality of fourth demolding portions 524 with respect to a center of the packaging body 500 in the length direction X of the power module 10. That is to say, the plurality of third demolding portions 523 are symmetrical to the plurality of fourth demolding portions 524 with respect to the left-right direction in FIG. 17.

Such arrangement may ensure that the power module 10 is subjected to even force in the demolding process, so that the power module 10 may be demolded smoothly. In addition, the third demolding portions 523 and the fourth demolding portions 524 are symmetrically disposed, which is also conducive to the processing.

It may be understood that a plurality of demolding portions 520 are also disposed on the first surface 501 of the packaging body 500, and the plurality of demolding portions 520 are dents left on the first surface 501 of the packaging body 500 in the demolding process. The plurality of demolding portions 520 are evenly distributed on the first surface 501, which is conducive to ensuring that the packaging body 500 is subjected to even force in the demolding process, thereby preventing the packaging body 500 from being damaged or deformed.

It may be seen from the description that the plurality of first demolding portions 521 and the plurality of second demolding portions 522 are relatively far away from a central axis ab of the power module 10 in the width direction Y of the power module 10, and the plurality of third demolding portions 523 and the plurality of fourth demolding portions 524 are relatively proximate to the central axis ab of the power module 10 in the width direction Y of the power module 10.

In some embodiments, as shown in FIGS. 7, 8, 14 and 15, the packaging body 500 may further include two notches 530. The two notches 530 may be located at two ends of the packaging body 500 in the length direction X of the power module 10, which is conducive to fixing the packaging body 500. For example, the notch 530 may be a notch in a shape of a circle or a U-shaped notch, which is conducive to the assembly of the power module 10 with other components. Centers of the two notches 530 may be located in the central axis ab of the power module 10 in the width direction Y of the power module 10.

On this basis, the number of the third demolding portions 523 and the number of the fourth demolding portions 524 are both two. In the width direction Y of the power module 10, the two third demolding portions 523 are located on two sides of a notch 530 proximate to the first side 503 of the packaging body 500, respectively, and the two fourth demolding portions 524 are located on two sides of a notch 530 proximate to the second side 504 of the packaging body 500, respectively.

For example, in a case where the centers of the two notches 530 are located in the central axis ab of the power module 10 in the width direction Y of the power module 10, two third demolding portions 523 are located on two sides of the central axis ab, respectively, and are symmetrical to each other with respect to the central axis ab, and two fourth demolding portions 524 are also located on two sides of the central axis ab, respectively, and are symmetrical to each other with respect to the central axis ab. In this way, the packaging body 500 may be prevented from being deformed or damaged in the demolding process, so that the service life of the packaging mold may be extended.

In some embodiments, as shown in FIG. 14, an intersection point between a line connecting two third demolding portions 523 and the central axis ab is located between the center of the notch 530 proximate to the first side 503 and an intersection point between the notch 530 and the central axis ab. An intersection point between a line connecting two fourth demolding portions 524 and the central axis ab is located between the center of the notch 530 proximate to the second side 504 and an intersection point between the notch 530 and the central axis ab.

Considering the power module 10 in FIG. 14 as an example, orthogonal projections of the centers of the two notches 530 on the surface of the packaging body 500 are point a and point b (a line connecting the point a and the point b is the central axis ab), respectively, and centers of two third demolding portions 523 are point c and point d, respectively. The point a is closer to the point c and the point d than the point b. An intersection point between the notch 530 and the central axis ab is point e, and an intersection point between a line connecting the point c and the point d and the central axis ab is point f, and the point f is located between the point a and the point e. On this basis, in the length direction X of the power module 10, two third demolding portions 523 are closer to the center of the packaging body 500 than the center a of the notch 530 at the left end. Similarly, in the length direction X of the power module 10, two fourth demolding portions 524 are closer to the center of the packaging body 500 than the center b of the notch 530 at the right end.

In this way, the third demolding portions 523 and the fourth demolding portions 524 are closer to the center of the packaging body 500 than the notches 530 located at two ends of the packaging body 500, which may improve the demolding stability of the power module 10 and avoid damage to the packaging body 500 in the demolding process, so that the service life of the packaging mold may be extended.

It may be seen from the embodiments described above that the heat dissipation substrate 100 has the third surface 101 and the fourth surface 102, and the fourth surface 102 of the heat dissipation substrate 100 is flush with the second surface 502 of the packaging body 500. As shown in FIGS. 2 to 4, the surface of the conductive layer 110 on which the power chip 200 is disposed is the third surface 101. In addition to the conductive layer 110, the heat dissipation substrate 100 may further include other film layers.

In some embodiments, as shown in FIG. 3, the heat dissipation substrate 100 may further include a ceramic layer 120 and a heat dissipation layer 130. In the thickness direction Z of the power module 10, the conductive layer 110 and the heat dissipation layer 130 are located on two sides of the ceramic layer 120, respectively. A surface of the heat dissipation layer 130 away from the conductive layer 110 is flush with the second surface 502 of the packaging body 500. That is to say, the surface of the heat dissipation layer 130 away from the conductive layer 110 is the fourth surface 102.

For example, the conductive layer 110 may be made of a metal material with high conductivity, such as copper. The heat dissipation layer 130 may be made of a metal material with high heat dissipation performance, such as copper. The ceramic layer 120 may be made of an insulating resin material, so as to avoid current dissipation. On this basis, the conductive layer 110, the ceramic layer 120 and the heat dissipation layer 130 may be a copper layer, a ceramic layer and a copper layer, respectively, which together form a direct bond copper (DBC) structure.

In this way, the heat generated by the power chips 200 during operation may be dissipated in time through the conductive layer 110, the ceramic layer 120 and the heat dissipation layer 130, so as to achieve heat dissipation of the power module 10, so that the reliability of the power chips 200 may be ensured and the performance of the power module 10 may be improved.

In some other embodiments, as shown in FIG. 4, the heat dissipation substrate 100 may further include a ceramic layer 120 located on a side of the conductive layer 110 away from the first surface 501. A surface of the ceramic layer 120 away from the conductive layer 110 is flush with the second surface 502 of the packaging body 500. That is to say, the surface of the ceramic layer 120 away from the conductive layer 110 is the fourth surface 102.

For example, the conductive layer 110 may be made of a metal material with high conductivity, such as copper, and the ceramic layer 120 may be made of an insulating material with high heat dissipation performance. On this basis, the conductive layer 110 and the ceramic layer 120 may form a single-sided copper-clad ceramic substrate, and the ceramic layer 120 has both insulation and heat dissipation functions.

In this way, the heat generated by the power chips 200 during operation may be dissipated in time through the conductive layer 110 and the ceramic layer 120, so as to achieve heat dissipation of the power module 10, so that the reliability of the power chips 200 may be ensured and the performance of the power module 10 may be improved.

In yet some other embodiments, as shown in FIG. 2, the conductive layer 110 and the power pin 600 form a one-piece structure. That is to say, the conductive layer 110 includes a portion located in the packaging body 500 and a portion extending out of the packaging body 500. The portion of the conductive layer 110 located in the packaging body 500 may serve as a pad for the power chip 200, and the portion of the conductive layer 110 extend out of the packaging body 500 may serve as the power pin 600. On this basis, the heat dissipation substrate 100 may further include an insulating resin heat dissipation sheet located on the side of the conductive layer 110 away from the first surface 501, and the insulating resin heat dissipation sheet is formed by connecting a side of the insulating resin sheet 140 to the heat dissipation sheet 150. Another side of the insulating resin sheet 140 is connected to the conductive layer 110 constituting the pad of the power chip 200, and a surface of the heat dissipation sheet 150 away from the conductive layer 110 is flush with the second surface 502 of the packaging body 500. That is to say, the surface of the heat dissipation sheet 150 away from the conductive layer 110 is the fourth surface 102. For example, the heat dissipation sheet 150 may be a copper sheet, and the insulating resin heat dissipation sheet is usually an insulating resin copper sheet.

In some embodiments, as shown in FIGS. 14 and 15, the packaging body 500 may further include a first step portion 540 and a second step portion 550 that are recessed inward with respect to two sides of the packaging body 500 in the width direction Y of the power module 10, and the first step portion 540 and the second step portion 550 are disposed opposite to each other. Here, the first step portion 540 and the second step portion 550 are recessed, which means that the first step portion 540 and the second step portion 550 are recessed toward the inside of the packaging body 500.

The first step portion 540 is located on a side of the portions of the plurality of driving pins 700 extending out, and the side is proximate to the second surface 502 of the packaging body 500, and the first step portion 540 is recessed in a direction from the plurality of driving pins 700 to the plurality of power pins 600. The first step portion 540 has a first step surface 541 and a first connecting surface 542 connected between the first step surface 541 and the second surface 502.

The second step portion 550 is located on a side of the portions of the plurality of power pins 600 extending out, and the side is proximate to the second surface 502 of the packaging body 500, and the second step portion 550 is recessed in a direction from the plurality of power pins 600 to the plurality of driving pins 700. The second step portion 550 has a second step surface 551 and a second connecting surface 552 connected between the second step surface 551 and the second surface 502.

In this way, the arrangement of the first step portion 540 and the second step portion 550 may reduce the space between the heat dissipation substrate 100 and a side of the cavity of the packaging mold corresponding to a side where the driving pins 700 are located and the space between the heat dissipation substrate 100 and a side of the cavity of the packaging mold corresponding to a side where the power pins 600 are located, which is conducive to reducing the amount of the resin accumulated in the two spaces in the process of injecting the resin, so that the risk of burrs caused by the resin overflowing from the bottom surface of the heat dissipation substrate 100 may be reduced.

On this basis, as shown in FIGS. 14 and 15, the plurality of first demolding portions 521 may be disposed on the first step surface 541 of the first step portion 540, and the plurality of second demolding portions 522 may be disposed on the second step surface 551 of the second step portion 550. The plurality of third demolding portions 523 and the plurality of fourth demolding portions 524 may be disposed on the second surface 502. Such arrangement may ensure that the demolding of the packaging body 500 is stable.

In some embodiments, the heat dissipation substrate 100 may adopt the DBC structure or the single-sided copper-clad structure. In this case, as shown in FIG. 20, the packaging body 500 may further include a resin injection portion 560 located on a side of the packaging body 500 where the power pins 600 are disposed. In the thickness direction Z of the power module 10, a distance H1 from the second step surface 551 of the second step portion 550 to the second surface 502 of the packaging body 500 is less than a distance H0 from the resin injection portion 560 to the second surface 502 of the packaging body 500, and the distance H1 from the second step surface 551 of the second step portion 550 to the second surface 502 of the packaging body 500 is less than a distance H5 from a surface of the power chip 200 away from the conductive layer 110 to the second surface 502 of the packaging body 500.

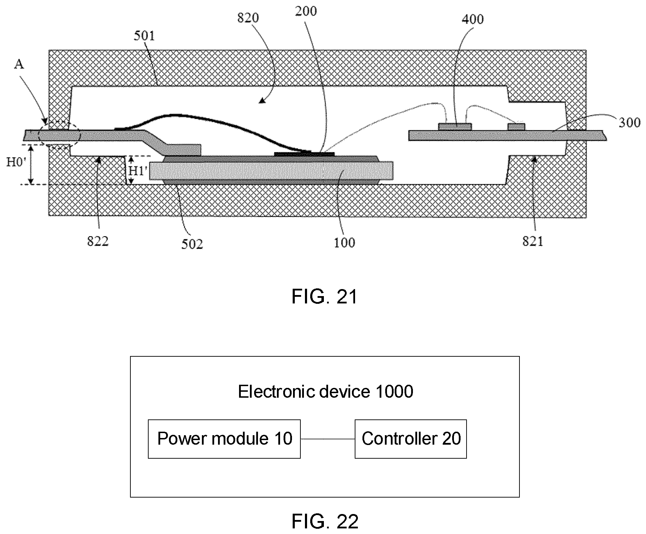

In the process of packaging the main structure of the power module 10, as shown in FIG. 21, the main structure of the power module 10 may be placed in the cavity 820 of the packaging mold. The packaging mold has a resin injection opening A. The liquid resin is injected into the cavity 820 through the resin injection opening A and fills between the main structure of the power module 10 and the walls of the cavity. The packaging body 500 in FIG. 20 may be formed after the resin cures, and a portion of the packaging body 500 corresponding to the resin injection opening A is the resin injection portion 560. Roughness of the resin injection portion 560 is greater than that of other portions of the packaging body 500.

It may be understood that a shape of the walls of the cavity of the packaging mold matches an outer shape of the packaging body 500. It may be seen that the cavity 820 of the packaging mold has a first step 821 corresponding to the first step portion 540 of the packaging body 500 and a second step 822 corresponding to the second step portion 550 of the packaging body 500. A distance H1' from a step surface of the second step 822 to a bottom surface of the cavity is less than a distance from the surface of the power chip 200 away from the conductive layer 110 to the bottom surface of the cavity, and the distance H1' from the step surface of the second step 822 to the bottom surface of the cavity is less than a height H0' (i.e., a distance from the resin injection opening A to the bottom surface of the cavity) of the resin injection opening A.

In this way, when the resin is injected into the cavity of the packaging mold through the resin injection opening A, the liquid resin first falls on the second step 822. The second step 822 has a certain buffering effect on the liquid resin, which reduces a height of the resin flowing toward the heat dissipation substrate 100, and reduces impact force of the resin on the heat dissipation substrate 100 in an inclined downward direction. On this basis, the height of the second step 822 is less than the distance from the top surface of the power chip 200 to the bottom surface of the cavity, so that the resin may flow to the power chip 200 from low to high. Therefore, the resin flows smoothly, which further reduces impact force of the resin on the heat dissipation substrate 100 and the power chips 200, thereby preventing the resin from overflowing to the back surface of the heat dissipation substrate 100 and alleviating the problem of possible displacement of the heat dissipation substrate 60.

In some embodiments, as shown in FIG. 20, in the thickness direction Z of the power module 10, the distance H1 from the second step surface 551 of the second step portion 550 to the second surface 502 of the packaging body 500 is substantially equal to a distance H2 from the first step surface 541 of the first step portion 540 to the second surface 502 of the packaging body 500; and/or, as shown in FIG. 15, in the width direction Y of the power module 10, a distance H3 from the second connecting surface 552 of the second step portion 550 to a third side 505 of the packaging body 500 proximate to the portions of the power pins 600 extending out of the packaging body is substantially equal to a distance H4 from the first connecting surface 541 of the first step portion 540 to a fourth side 506 of the packaging body 500 proximate to the portions of the driving pins 700 extending out of the packaging body. Such arrangement may simplify the manufacturing process while buffering the resin.

In some embodiments, as shown in FIGS. 15 and 20, the first step portion 540 may include a first main body portion extending in the length direction X of the power module 10, a first end portion extending in the width direction Y of the power module 10, and a first flow guide portion 545 connected between the first main body portion and the first end portion; and/or, the second step portion 550 may include a second main body portion extending in the length direction X of the power module 10, a second end portion extending in the width direction Y of the power module 10, and a second flow guide portion 555 connected between the second main body portion and the second end portion.

The first flow guide portion 545 and the second flow guide portion 555 may both be a chamfer, a rounded corner, a groove, or other structures capable of achieving a function of guiding the resin to flow. Component force guiding the resin to the opposite side may be provided to push the resin to flow by providing the flow guide portion at a corner of the first step portion 540 and/or the second step portion 550, thereby avoiding gaps existing in the resin caused by the stagnation and accumulation of the resin when the resin flows to the corners.

For example, the first step portion 540 may include only one first flow guide portion 545, or may include two first flow guide portions 545, each first flow guide portion 545 is connected between the first end portion and the first main body portion.

For another example, the second step portion 550 may include only one second flow guide portion 555, or may include two second flow guide portions 555, and each second flow guide portion 555 is connected between the second end portion and the second main body portion.

It will be noted that, in addition to forming the flow guide portion at the corner of the first step portion 540 and/or the second step portion 550, the flow guide portion may also be formed at a corner between any two adjacent sides of the first side 503, the second side 504, the third side 505 and the fourth side 506 of the packaging body 500.

In this way, when the liquid resin flows to the corner in the cavity corresponding to the flow guide portion, the flow guide portion may facilitate the flow of the resin, so as to avoid gaps existing in the resin caused by the stagnation and accumulation of the resin. In addition, the arrangement of the flow guide portion may also reduce the accumulated amount of the resin, so that the risk of burrs caused by the resin overflowing from the bottom surface of the heat dissipation substrate 100 may be further reduced.

An electronic device is provided in the embodiments of the present disclosure, and the power module in at least one of the embodiments described above may be applied to the electronic device. As shown in FIG. 22, the electronic device 1000 may include a power module 10 and a controller 20 connected to the power module 10.

For example, the controller 20 may generate a control signal according to a user instruction and send the control signal to the power module 10. The power module 10 may generate a driving signal according to the control signal and output the driving signal to the corresponding driving component, so as to achieve the corresponding function.

It will be noted that the electronic device provided in the embodiments of the present disclosure has the same technical effects as the power module in the embodiments described above included by the electronic device, and details will not be repeated herein.

In the description of the present disclosure, a first feature is "on" or "under" a second feature, which may mean that the first feature and the second feature are directly in contact with each other, or may mean that the first feature and the second feature are not in direct contact with each other but are in contact with each other through another feature therebetween. The first feature is "on" the second feature, which may mean that the first feature is directly on or obliquely on the second feature, or merely means that a horizontal height of the first feature is higher than that of the second feature.

In the description of the present disclosure, it will be understood that, orientations or positional relationships indicated by the terms such as "center", "longitudinal", "transverse", "length", "width", "thickness", "up", "down", "front", "back", "left", "right", "vertical", "horizontal", "top", "bottom", "inside" and "outside", "clockwise", "anticlockwise", "axial direction", "radial direction", "peripheral direction", are based on orientations or positional relationships shown in the drawings, which is merely for convenience in description of the present disclosure and simplifying the description, but not to indicate or imply that the indicated device or element must have a specific orientation, or be constructed and operated in a specific orientation.

Although the embodiments of the present disclosure have been shown and described, a person of ordinary skill in the art will understand that: various changes, modifications, substitutions and variations may be made to the embodiments without departing from the principles and spirit of the present disclosure, and the scope of the present disclosure is limited by the claims and their equivalents.

A person skilled in the art will understand that the scope of disclosure in the present disclosure is not limited to the specific embodiments described above, and may modify and substitute some elements of the embodiments without departing from the concept of present disclosure. The scope of the present disclosure is limited by the appended claims.

## Claims

1. A power module, comprising:
a packaging body having a first surface and a second surface disposed opposite to each other in a thickness direction of the power module; the packaging body including one or more residual portions located on the first surface;
a heat dissipation substrate disposed in the packaging body and having a third surface and a fourth surface disposed opposite to each other in the thickness direction of the power module; the heat dissipation substrate including a conductive layer, a surface of the conductive layer proximate to the first surface being the third surface, and the fourth surface being flush with the second surface, so that the fourth surface is exposed from the packaging body; and
a plurality of power chips disposed on the conductive layer and arranged at intervals in a length direction of the power module;
wherein orthogonal projections of edges of the one or more residual portions on the conductive layer are staggered with orthogonal projections of edges of the power chips on the conductive layer.

2. The power module according to claim 1, wherein a minimum distance A between an orthogonal projection of a power chip closest to the residual portion in the plurality of power chips on the conductive layer and the orthogonal projection of the edge of the residual portion on the conductive layer is greater than 0.45 mm (i.e., A > 0.45 mm).

3. The power module according to claim 1 or 2, wherein the conductive layer includes a plurality of base islands arranged at intervals in the length direction of the power module, and the plurality of power chips are disposed on the plurality of base islands; and
a dimension of the heat dissipation substrate in the length direction of the power module is L, the one or more residual portions include n residual portions, L is less than or equal to 40 mm (i.e., L ≤ 40 mm), and n is greater than or equal to 2 and less than or equal to 4 (i.e., 2 ≤ n ≤ 4), and L and n are both positive integers;
wherein the n residual portions at least include two residual portions located at two ends in the length direction of the power module; in the thickness direction of the power module, the two residual portions located at the two ends correspond to two base islands located at two ends in the length direction of the power module in the plurality of base islands.

4. The power module according to claim 3, wherein in a case where L is less than or equal to 25 mm (i.e., L ≤ 25 mm), n is equal to 2 (i.e., n = 2); a minimum distance between two adjacent power chips is B, a maximum section dimension of the residual portion is C, and B is less than a sum of C and 0.8 mm (i.e., B < C + 0.8 mm);
in a case where L is greater than 25 mm and less than or equal to 32 mm (i.e., 25 mm < L ≤ 32 mm), n is equal to 3 (i.e., n = 3); an orthogonal projection of a residual portion located in a middle in the length direction of the power module in the n residual portions on the conductive layer overlaps with two adjacent base islands in the plurality of base islands simultaneously; and
in a case where L is greater than 32 mm and less than or equal to 40 mm (i.e., 32 mm < L ≤ 40 mm), n is equal to 4 (i.e., n = 4); orthogonal projections of two residual portions located in the middle in the length direction of the power module in the n residual portions on the conductive layer overlap with two base islands located in a middle in the plurality of base islands, respectively.

5. The power module according to claim 1 or 2, wherein the conductive layer includes a plurality of base islands arranged at intervals in the length direction of the power module, and the plurality of power chips are disposed on the plurality of base islands; and
a dimension of the heat dissipation substrate in the length direction of the power module is L, the one or more residual portions include n residual portions, L is greater than 40 mm (i.e., L > 40 mm) and n is greater than 4 (i.e., n > 4), L and n are both positive integers;
wherein in the thickness direction of the power module, each base island corresponds to at least one residual portion.

6. The power module according to claim 5, wherein n is equal to 5 (i.e., n = 5), the plurality of base islands include a first base island, a second base island, a third base island and a fourth base island that are sequentially arranged at intervals in the length direction of the power module; an area of the fourth base island is greater than areas of the first base island, the second base island and the third base island;
wherein orthogonal projections of three of the n residual portions on the conductive layer overlap with the first base island, the second base island and the third base island, respectively, and orthogonal projections of another two of the n residual portions on the conductive layer overlap with the fourth base island.

7. The power module according to claim 5, wherein n is greater than 5 (i.e., n > 5), the plurality of base islands include a first base island, a second base island, a third base island and a fourth base island that are sequentially arranged at intervals in the length direction of the power module; an area of the fourth base island is greater than areas of the first base island, the second base island and the third base island;
wherein in the n residual portions, an orthogonal projection of a residual portion on the conductive layer overlaps with an edge of a side of the first base island away from the second base island, orthogonal projections of another three residual portions on the conductive layer overlap with edges of the first base island and the second base island that are proximate to each other, edges of the second base island and the third base island that are proximate to each other, and edges of the third base island and the fourth base island that are proximate to each other, respectively, and orthogonal projections of remaining residual portions on the conductive layer overlap with the fourth base island.

8. The power module according to any one of claims 1 to 7, wherein two sides of the power module in a width direction of the power module are a driving side and a power side, respectively; the conductive layer includes a plurality of base islands arranged at intervals in the length direction of the power module, and the one or more residual portions include n residual portions;
in a case where n is less than or equal to 5 (i.e., n ≤ 5), orthogonal projections of the n residual portions on the conductive layer overlap with edges of the plurality of base islands located on the driving side; and
in a case where n is greater than 5 (i.e., n > 5), the orthogonal projections of the n residual portions on the conductive layer are located in middle portions of the plurality of base islands in the width direction of the power module.

9. The power module according to claim 8, wherein in a case where n is less than or equal to 5 (i.e., n ≤ 5), orthogonal projections of centers of two residual portions at two ends in the length direction of the power module on the conductive layer coincide with vertexes of two corners of the conductive layer located on the driving side, respectively.

10. The power module according to any one of claims 1 to 9, wherein the packaging body further includes a plurality of demolding portions located on the second surface; the plurality of demolding portions include:
a plurality of first demolding portions and a plurality of second demolding portions located at two edges of the second surface in a width direction of the power module, respectively; the plurality of first demolding portions being arranged at intervals in the length direction of the power module, and the plurality of second demolding portions being arranged at intervals in the length direction of the power module; and
a plurality of third demolding portions and a plurality of fourth demolding portions located between the plurality of first demolding portions and the plurality of second demolding portions in the width direction of the power module; in the length direction of the power module, the plurality of third demolding portions being located between the heat dissipation substrate and a first side of the packaging body, and the plurality of fourth demolding portions being located between the heat dissipation substrate and a second side of the packaging body.

11. The power module according to claim 10, wherein the plurality of third demolding portions are planar symmetrical to each other with respect to a center of the packaging body in the width direction of the power module, and the plurality of fourth demolding portions are planar symmetrical to each other with respect to the center of the packaging body in the width direction of the power module; and/or
the plurality of third demolding portions are planar symmetrical to the plurality of fourth demolding portions with respect to a center of the packaging body in the length direction of the power module.

12. The power module according to claim 11, wherein the packaging body includes two notches, and the two notches are located at two ends of the packaging body in the length direction of the power module;
the plurality of third demolding portions include two third demolding portions; in the width direction of the power module, the two third demolding portions are located on two sides of a notch proximate to the first side, respectively; and
the plurality of fourth demolding portions include two fourth demolding portions; in the width direction of the power module, the two fourth demolding portions are located on two sides of a notch proximate to the second side, respectively.

13. The power module according to claim 12, wherein centers of the two notches are located in a central axis of the power module in the width direction of the power module;
an intersection point between a line connecting the two third demolding portions and the central axis is located between the center of the notch proximate to the first side and an intersection point between the notch and the central axis; and
an intersection point between a line connecting the two fourth demolding portions and the central axis is located between the center of the notch proximate to the second side and an intersection point between the notch and the central axis.

14. The power module according to any one of claims 1 to 13, wherein the heat dissipation substrate further includes a ceramic layer and a heat dissipation layer; the conductive layer and the heat dissipation layer are located on two sides of the ceramic layer in the thickness direction of the power module, respectively; a surface of the heat dissipation layer away from the conductive layer is the fourth surface; or
the heat dissipation substrate further includes the ceramic layer located on a side of the conductive layer away from the first surface, and a surface of the ceramic layer away from the conductive layer is the fourth surface.

15. The power module according to any one of claims 1 to 14, further comprising:
a driving frame disposed in the packaging body;
at least one driving chip disposed on the driving frame; the at least one driving chip being electrically connected to the plurality of power chips;
a plurality of driving pins arranged at intervals in the length direction of the power module; an end of the driving pin being connected to the driving frame, and another end of the driving pin extending out of the packaging body; and
a plurality of power pins arranged at intervals in the length direction of the power module; an end of the power pin being connected to the conductive layer, and another end of the power pin extending out of the packaging body;
wherein the plurality of driving pins and the plurality of power pins are located on two sides of the power module in a width direction of the power module, respectively.

16. The power module according to claim 15, wherein the packaging body further includes:
a second step portion located on a side of portions of the plurality of power pins extending out of the packaging body, the side being proximate to the second surface of the packaging body, and the second step portion being recessed in a direction from the plurality of power pins to the plurality of driving pins; the second step portion having a second step surface and a second connecting surface connected between the second step surface and the second surface;
wherein in the thickness direction of the power module, a distance from the second step surface of the second step portion to the second surface of the packaging body is less than a distance from a surface of the power chip away from the conductive layer to the second surface of the packaging body.

17. The power module according to claim 16, wherein the packaging body further includes: a first step portion located on a side of portions of the plurality of driving pins extending out of the packaging body, the side being proximate to the second surface of the packaging body, and the first step portion being recessed in a direction from the plurality of driving pins to the plurality of power pins; the first step portion having a first step surface and a first connecting surface connected between the first step surface and the second surface; and
a plurality of demolding portions including:
a plurality of first demolding portions located on the first step surface, the plurality of first demolding portions being arranged at intervals in the length direction of the power module;
a plurality of second demolding portions located on the second step surface, the plurality of second demolding portions being arranged at intervals in the length direction of the power module; and
a plurality of third demolding portions and a plurality of fourth demolding portions located on the second surface; in the length direction of the power module, the plurality of third demolding portions being located between the heat dissipation substrate and a first side of the packaging body, and the plurality of fourth demolding portions being located between the heat dissipation substrate and a second side of the packaging body.

18. The power module according to claim 17, wherein in the thickness direction of the power module, the distance from the second step surface of the second step portion to the second surface of the packaging body is substantially equal to a distance from the first step surface of the first step portion to the second surface of the packaging body; and/or, in the width direction of the power module, a distance from the second connecting surface of the second step portion to a third side of the packaging body proximate to the portions of the power pins extending out of the packaging body is substantially equal to a distance from the first connecting surface of the first step portion to a fourth side of the packaging body proximate to the portions of the driving pins extending out of the packaging body.

19. The power module according to claim 18, wherein the first step portion includes a first flow guide portion located at a corner; and/or, the second step portion includes a second flow guide portion located at a corner.

20. An electronic device, comprising the power module according to any one of claims 1 to 19.
